# EUROPÄISCHE PATENTANMELDUNG

(11) **EP 1 369 974 A2**
(43) Veröffentlichungstag der Anmeldung: **10.12.2003**
(21) Anmeldenummer: 03012571.0
(22) Anmeldetag: 03.06.2003
(51) Int. Cl.: H02J 7/32

(54) **Drahtloses Kommunikationsnetzwerk**

(30) Priorität: 06.06.2002 DE 10225361
(71) Anmelder: EADS Deutschland GmbH, 85521 Ottobrunn (DE)
(72) Erfinder: Jänker, Peter, Dr., 85521 Riemerling (DE)

(57) **Zusammenfassung**

Die vorliegende Erfindung betrifft ein drahtloses Kommunikationsnetzwerk, bestehend aus einer Vielzahl einzelner miteinander drahtlos in kommunizierender Verbindung stehender Kommunikationselemente (10), die jeweils eine Eingabe/Ausgabe-Einheit (1), eine Empfangseinheit (2), eine Speichereinheit (3), eine Bearbeitungseinheit (4), eine Sendeeinheit (5) sowie eine Energieversorgungseinheit (6) umfassen, und dadurch gekennzeichnet ist, dass die Energieversorgungseinheit (6) Energie in Form von Wärme oder mechanischer Schwingung aus der Umgebung aufnimmt und diese in elektrische Energie zur Versorgung des entsprechenden Kommunikationselementes (10) umwandelt.

## Beschreibung

Die vorliegende Erfindung betrifft ein drahtloses Kommunikationsnetzwerk gemäß dem Oberbegriff des Anspruchs 1.

Zahlreiche Systeme zur drahtlosen Datenübertragung bzw. Kommunikation sind bekannt, die in Mobiltelefonen, Fernsteuerungen, Fahrzeug-Bordsystemen, um nur einige Anwendungen zu nennen, genutzt werden. Die Kommunikation erfolgt üblicherweise zwischen einer Basiseinheit und damit in Verbindung stehender Peripherieeinheiten. Es sind auch Konfigurationen möglich, bei der die einzelnen Peripherieeinheiten untereinander in kommunizierender Verbindung stehen. Hierbei werden bekanntlich verschiedene elektronische Komponenten eingesetzt, wie z.B. Empfänger und Sendeeinheiten, um ein Empfangen und Senden von Daten zu gewährleisten. Daneben sind Speicher- und Bearbeitungseinheiten zur Datenverarbeitung erforderlich, sowie Eingabe/Ausgabe-Einheiten zur Eingabe von Befehlen durch einen Anwender.

Derartige drahtlose Kommunikationssysteme ermöglichen die Reduzierung des ansonsten erforderlichen Verdrahtungsaufwandes. Dies bedeutet auch, dass ein Auswechseln einzelner Einheiten bzw. Komponenten einfacher durchzuführen ist, da nicht auf eine entsprechende Verdrahtung geachtet werden muss.

Zur Energieversorgung des Kommunikationssystems ist dieses meist mit einer externen Energiequelle verbunden. Alternativ können Primärbatterien oder Akkumulatoren in die Peripherieeinheiten eingesetzt werden. Dies erfordert jedoch von Zeit zu Zeit ein Austauschen bzw. Nachladen, was einen entsprechenden Wartungsaufwand erfordert und für manche Anwendungen von Nachteil ist. Daneben kann die Stromversorgung in drahtlosen Kommunikationssystemen auch mit Hilfe von Solarzellen bewerkstelligt werden, wie das beispielsweise in DE 100 17 856 A1 beschrieben ist. Hierbei besteht jedoch der Nachteil, dass insbesondere bei einer dauerhaften Anwendung des Kommunikationssystems im Dunklen eine ausreichende Energieversorgung nicht gewährleistet ist.

Somit liegt der vorliegenden Erfindung die Aufgabe zu Grunde, ein drahtloses Kommunikationsnetzwerk zu schaffen, das umgebungsunabhängig einsetzbar ist und einen einfachen und damit kostengünstigen Aufbau aufweist, wobei das Netzwerk einfach modifizierbar und rekonfigurierbar ist.

Die Aufgabe wird durch ein Kommunikationsnetzwerk gelöst, das aus einer Vielzahl einzelner miteinander drahtlos in kommunizierender Verbindung stehender Kommunikationselemente besteht, die jeweils eine Eingabe/Ausgabe-Einheit, eine Empfangseinheit, eine Speichereinheit, eine Bearbeitungseinheit, eine Sendeeinheit sowie eine Energieversorgungseinheit umfassen, wobei die Energieversorgungseinheit Energie in Form von Wärme oder mechanischer Schwingung aus der Umgebung aufnimmt und diese in elektrische Energie zur Versorgung des entsprechenden Kommunikationselementes umwandelt.

Eine derartige Anordnung hat neben der erheblichen Gewichts- und Kosteneinsparung durch Wegfall der Verkabelung sowie deren Tests den Vorteil unabhängig von einer externen Energieversorgung zu sein. Somit ist kein Anschluss zu einer z.B. im Netzwerk zentral vorgesehenen Energieversorgung oder ein Auswechseln/Aufladen von Batterien/Akkumulatoren erforderlich. Darüber hinaus besteht der Vorteil, dass das Kommunikationsnetzwerk durch das in Wechselwirkungstehen der einzelnen Kommunikationselemente sich automatisch an gegebene Anforderungen anpasst; d.h. ein Software-Update ist schnell und problemlos durchzuführen, so dass eine einfache Rekonfigurierbarkeit des Kommunikationsnetzwerkes besieht. Zudem ist eine beliebige Vernetzung bzw. Anordnung einzelner Kommunikationselemente ohne großen Aufwand möglich.

Gemäß einer ersten Ausführungsform umfasst die Energieversorgungseinheit ein Piezoelement, das Vibrationen in elektrische Energie zur elektrischen Versorgung des jeweiligen Kommunikationselementes umwandelt. Die Verwendung eines Piezoelementes ist insbesondere auf Grund der hohen Empfindlichkeit hinsichtlich der Erzeugung von elektrischen Ladungsverteilungen bei mechanischer Verformung vorteilhaft. Bereits geringe Vibrationen reichen aus, um auf Grund der dadurch hervorgerufenen Druckschwankungen eine periodische elektrische Ladungstrennung und damit Speisestrom bzw. elektrische Leistung zu erzeugen, so dass beispielsweise eine Anwendung in Flugzeugen, Fahrzeugen oder anderen sich bewegenden Systemen möglich ist.

Gemäß einer alternativen Ausführungsform ist in der Energieversorgungseinheit ein pyroelektrischer Generator vorgesehen, der Wärme in elektrische Energie umwandelt. Der Einsatz eines pyroelektrischen Generators ist insbesondere dann vorteilhaft, wenn das Kommunikationssystem in einer Umgebung mit Wärmequellen mit großen Temperaturdifferenzen eingesetzt wird. Dies tritt z.B. im Flugzeug auf, bei dem ein großer Temperaturgradient zwischen Außenhülle und Innenhülle (d.h. Kabine) besteht. Die Temperatur der Außenhülle beträgt beispielsweise -40°C, wohingegen die Innenhülle eine Temperatur von beispielsweise 60°C aufweist.

Ferner ist es zweckmäßig, dass die Energieversorgungseinheit einen Energiespeicher aufweist, der die mittels Piezoelement bzw. pyroelektrischen Generator generierte elektrische Energie speichert. Dadurch ist es möglich, kontinuierlich Energie zu speichern, unabhängig davon, ob das Kommunikationsnetzwerk in Betrieb ist oder nicht. Auf diese Weise wird sichergestellt, dass zu jeder Zeit ausreichend Energie zum Betrieb des Kommunikationsnetzwerkes zur Verfügung steht.

Vorteilhafterweise sind die jeweiligen Komponenten der Kommunikationselemente sogenannte "low-power"-Bauteile. Das heisst, sie benötigen einen geringen Energiebedarf, was einen ökonomischen Betrieb des Kommunikationsnetzwerkes gewährleistet.

Gemäß einer alternativen Ausführungsform ist innerhalb des Kommunikationsnetzwerkes eine Zentraleinheit vorgesehen, die jeweils mit den Kommunikationselementen in drahtloser Kommunikation steht. Daneben kann auch eines der Kommunikationselemente als derartige Zentraleinheit ausgebildet sein.

Nachstehend wird die Erfindung anhand der beigefügten Abbildungen in näheren Einzelheiten beschrieben. In denen zeigt:
- **Fig. 1**: eine schematische Darstellung des erfindungsgemäßen Kommunikationsnetzwerkes; und
- **Fig. 2**: eine schematische Darstellung der in dem Kommunikationsnetzwerk gemäß Fig. 1 verwendeten Kommunikationselemente.

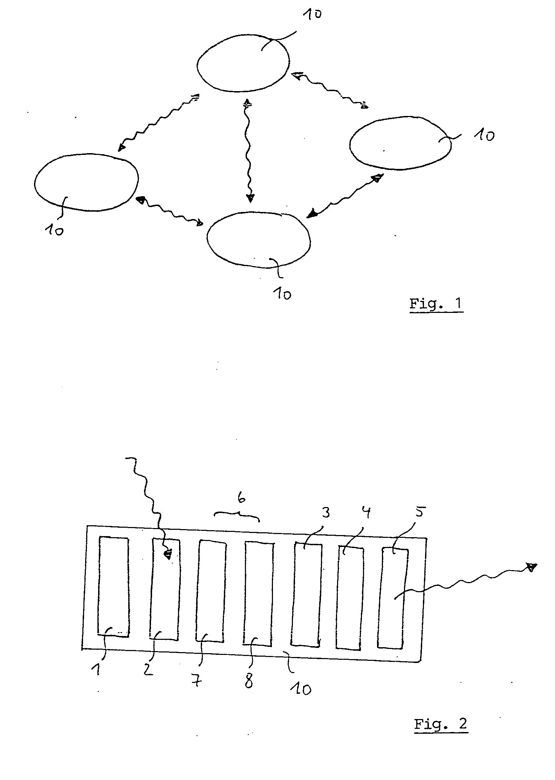

Fig. 1 zeigt in schematischer Darstellung ein Kommunikationsnetzwerk, das eine Vielzahl von Kommunikationselementen 10 umfasst, die jeweils untereinander drahtlos in kommunizierender Verbindung stehen. Auf Grund der drahtlosen Komponentenverschaltung entfällt der Einsatz von schweren und mechanisch aufwendigen Kabelsätzen, was zu einer erheblichen Gewichts- und Kosteneinsparung durch Wegfall der Verkabelung sowie deren Tests führt. Dies ermöglicht gleichzeitig eine beliebige Art der Vernetzung bzw. Anordnung beliebig vieler Kommunikationselemente 10. Die Kommunikationselemente 10 sind dabei an einem gewünschten Wirkungsort befestigt, beispielsweise an der Bedientafel eines Flugzeugsitzes, um bei Betätigung des Schalters ein Rufsignal für eine Stewardess auszulösen.

Der Aufbau eines einzelnen Kommunikationselementes 10 ist schematisch in Fig. 2 dargestellt. Das Kommunikationselement 10 umfasst eine Eingabe/Ausgabe-Einheit 1, über die der Anwender einen entsprechenden Befehl eingibt. Ferner ist ) im Kommunikationselement 10 eine Empfangseinheit 2 vorgesehen, um Daten bzw. Information von anderen in dem Kommunikationsnetzwerk vorhandenen Kommunikationselementen 10 zu empfangen. Des Weiteren ist eine Speichereinheit 3 sowie eine Bearbeitungseinheit 4 (z.B. eine CPU) vorgesehen, die zur elektronischen Datenverarbeitung dienen. Zur Weiterleitung der Daten ist eine Sendeeinheit 5 vorgesehen, die Information an die anderen im Kommunikationsnetzwerk angeordneten Kommunikationselemente 10 sendet. In dem Kommunikationselement 10 ist ferner eine Energieversorgungseinheit 6 vorgesehen, um die elektrische Versorgung des Kommunikationselementes 10 zu gewährleisten. Die Energieversorgungseinheit 6 nimmt Energie in Form von Wärme oder mechanischer Schwingung aus der Umgebung auf und wandelt diese in elektrische Energie um. Zu diesem Zweck ist in der Energieversorgungseinheit 6 gemäß einer ersten Ausführungsform ein Piezoelement 7 angeordnet. Die Funktionsweise des Piezoelementes 7 beruht auf dem bekannten piezoelektrischen Effekt, wobei im vorliegenden Fall das Ausbilden einer elektrischen Ladungstrennung bei mechanischer Verformungsbeaufschlagung ausgenutzt wird. Dies erfolgt mit hoher Empfindlichkeit, so dass die auf das Piezoelement einwirkenden Vibrationen in elektrische Leistung umgewandelt werden.

Gemäß einer weiteren Ausführungsform wird anstelle des Piezoelementes 7 ein pyroelektrischer Generator 7' verwendet, der auf bekannte Weise Wärme in elektrische Energie umwandelt. Ein derartiger pyroelektrischer Generator ist beispielsweise ein Peltier-Element. Daneben sind auch noch andere Formen der Aufnahme von Energie aus der Umgebung denkbar, wie beispielsweise die elektromagnetische Induktion. Hierzu wird in dem Kommunikationselemet 10 ein Induktionselement 7" (nicht dargestellt) verwendet.

Zur Speicherung der durch die genannten Komponenten 7, 7', 7" erzeugten elektrischen Energie, ist femer ein Energiespeicher 8 vorgesehen, der die Energie unabhängig davon speichern, ob das Kommunikationsnetzwerk in Betrieb ist oder nicht. Auf diese Weise wird bei Nichtbetreiben des Kommunikationsnetzwerkes der Energiespeicher 8 aufgeladen, so dass zu jedem Zeitpunkt ausreichend Energie zum Betrieb des Kommunikationsnetzwerkes zur Verfügung steht. Um ferner eine effektive Wirkungsweise des Kommunikationsnetzwerkes zu gewährleisten, sind die individuellen Komponenten 1 bis 5 sogenannte "low-power"-Bauteile, deren Energiebedarf so gering wie möglich ist.

Ferner ist anzumerken, dass in dem Kommunikationsnetzwerk gemäß Fig. 1 auch eine Zentraleinheit vorgesehen werden kann, oder dass eines der Kommunikationselemente 10 als derartige Zentraleinheit ausgebildet ist. Ebenso ist eine Ausgestaltung des Kommunikationsnetzwerkes nach Fig. 1 zum Relaybetrieb möglich.

Auf Grund der Anordnung der Kommunikationselemente 10 sowie deren drahtloser Kommunikation untereinander, ist beispielsweise ein Software-Update bzw. ein Umprogrammieren des Netzwerks auf einfache Weise möglich, da die neue Information von einem Kommunikationselement 10 zum anderen unmittelbar weitergeleitet wird. Das bedeutet, dass sich das Kommunikationsnetzwerk selbstorganisiert, wodurch ein Rekonfigurieren des Netzwerkes problemlos und mit geringem Aufwand realisiert werden kann. Eine derartige Rekonfiguration ist beispielsweise bei einer Umbestuhlung bei dem eingangs genannten Anwendungsbeispiel erforderlich. Daneben stehen in der Regel unterschiedliche Versionsmanagements z.B. bei Pkw-Varianten oder Sonderausstattungen zur Verfügung, an die das Kommunikationsnetzwerk schnell angepasst werden muss.

## Patentansprüche

1. Drahtloses Kommunikationsnetzwerk, bestehend aus einer Vielzahl einzelner miteinander drahtlos in kommunizierender Verbindung stehender Kommunikationselemente (10), die jeweils eine Eingabe/Ausgabe-Einheit (1), eine Empfangseinheit (2), eine Speichereinheit (3), eine Bearbeitungseinheit (4), eine Sendeeinheit (5) sowie eine Energieversorgungseinheit (6) umfassen, **dadurch gekennzeichnet, dass** die Energieversorgungseinheit (6) Energie in Form von Wärme oder mechanischer Schwingung aus der Umgebung aufnimmt und diese in elektrische Energie zur Versorgung des entsprechenden Kommunikationselementes (10) umwandelt.

2. Drahtloses Kommunikationsnetzwerk nach Anspruch 1, **dadurch gekennzeichnet, dass** die Energieversorgungseinheit (6) ein Piezoelement (7) umfasst, das Vibrationen in elektrische Energie umwandelt.

3. Drahtloses Kommunikationsnetzwerk nach Anspruch 1, **dadurch gekennzeichnet, dass** die Energieversorgungseinheit (6) einen pyroelektrischen Generator (7') umfasst, der Wärme in elektrische Energie umwandelt.

4. Drahtloses Kommunikationsnetzwerk nach einem der vorangegangenen Ansprüche, **dadurch gekennzeichnet, dass** die Energieversorgungseinheit (6) einen Energiespeicher (8) zum Speichern der mittels Piezoelement (7) oder pyroelektrischen Generators (7') generierten elektrischen Energie umfasst.

5. Drahtloses Kommunikationsnetzwerk nach einem der vorangegangenen Ansprüche dardurch gekennzeichnet,dass die Eingabe/Ausgabe-Einheit (1), die Empfangseinheit (2), die Speichereinheit (3), die Bearbeitungseinheit sowie die Sendeeinheit (5) Komponenten sind, die einen geringen Leistungsbedarf haben.

6. Drahtloses Kommunikationsnetzwerk nach einem der vorangegangenen Ansprüche, **dadurch gekennzeichnet, dass** eine Zentraleinheit vorgesehen ist, mit denen die Vielzahl von Kommunikationselementen (10) in drahtloser Kommunikation stehen.
